# EUROPEAN PATENT SPECIFICATION

(11) **EP 4 152 019 B1**
(45) Date of publication and mention of the grant of the patent: **21.05.2025**
(21) Application number: 22195931.5
(22) Date of filing: 15.09.2022
(51) Int. Cl.: H02P 27/08, G01R 31/34

(54) **CURRENT-SAMPLING METHOD, CHIP, AND SAMPLING APPARATUS FOR PHASE CURRENT OF MOTOR**
STROMABTASTUNGSVERFAHREN, CHIP UND ABTASTVORRICHTUNG FÜR DEN PHASENSTROM EINES MOTORS
PROCÉDÉ D'ÉCHANTILLONNAGE DE COURANT, PUCE ET APPAREIL D'ÉCHANTILLONNAGE POUR COURANT DE PHASE DE MOTEUR

(30) Priority: 15.09.2021 CN 202111080891
(43) Date of publication of application: 22.03.2023
(73) Proprietor: Autochips Wuhan Co., Ltd., 430206 Wuhan (CN)
(72) Inventor: PENG, Zhihao, Wuhan, 430206 (CN)
(74) Representative: Herrero & Asociados, S.L.

(56) References cited:
- US-A1- 2009 284 194
- US-A1- 2012 169 263

## Description

### TECHNICAL FIELD

The present disclosure generally relates to the technical field of motor control, and in particular, to a current-sampling method, a chip, and a sampling apparatus for a phase current of a motor.

### BACKGROUND

With the increasing demand for convenience and precision of a motor, users usually hope to control the motor quickly and accurately at runtime for better user experience in operation.

Typically, the motor collects currents at runtime. Based on the collected currents, a control method of the motor is field-oriented control (FOC), that is, the motor is controlled using the FOC algorithm.

At present, since the FOC algorithm uses single resistor sampling, it is needed to acquire a phase current within a pulse width modulation (PWM) period. Since a current sampling region within the PWM period includes a non-sector region and a sector region, when using the FOC algorithm, the algorithm cannot acquire phase current signals completely in the sector region, such as at a boundary of the sector region.

The US patent application US20090284194A1 discloses a method for measuring current in each phase of a three-phase inverter driven motor, which is based on the three-phase inverter being controlled in a PWM mode by three PWM signals including the use of a common DC-link current sensing resistor. The current on the sensing resistor is intermittently sampled. The method includes determining a modulation index for the voltage demand set by a motor controller. Based on specific mutual duty cycle conditions of the three PWM phase driving signals, sampling windows of sufficient duration are created for allowing distinct sampling of two of the phase currents.

The US patent application US20120169263A1 discloses methods, systems and apparatus for controlling operation of a multi-phase machine in a vector controlled motor drive system when the multi-phase machine operates in an overmodulation region. The disclosed embodiments provide a mechanism for adjusting a duty cycle of PWM waveforms so that the correct phase voltage command signals are applied at the angle transitions. This can reduce variations/errors in the phase voltage command signals applied to the multi-phase machine so that phase current may be properly regulated thus reducing current/torque oscillation, which can in turn improve machine efficiency and performance, as well as utilization of the DC voltage source.

### SUMMARY OF THE DISCLOSURE

The present disclosure is set out in the appended set of claims.

Different from the related art, the benefits of the present disclosure is that the present disclosure reduces distortion and improves an efficiency for current sampling by employing a phase-current sampling method for motor control including operations: identifying whether a waveform of a current period falls at a boundary of a sector region where a phase current of at least one phase is unable to be collected; determining a first duty cycle and a transforming channel mode for a channel of the at least one phase; storing the first duty cycle and the transforming channel mode in a buffer, and enabling a direct memory access (DMA) mode to the buffer at the same time; transforming a part of the waveform of the current period by configuring the channel of the at least one phase with the first duty cycle and the transforming channel mode, such that the condition of acquiring phase current samples may be satisfied at the boundary of the sector region, and the phase current may be acquired at the boundary of the sector region.

### BRIEF DESCRIPTION OF THE DRAWINGS

In order to illustrate the technical solutions in the embodiments of the present disclosure more clearly, the appended drawings needed in the descriptions of the embodiments are briefly introduced below. Obviously, the below described drawings are only some specific embodiments of the present disclosure. For a person skilled in the art, other drawings may be obtained based on the given drawings without creative work.
FIG. 1 is a schematic flowchart of a current-sampling method according to a first embodiment of the present disclosure.
FIG. 2 is a specific schematic flowchart of operations executed in a block S11 shown in FIG.1 according to some embodiments of the present disclosure.
FIG. 3 is another specific schematic flowchart of operations executed in the block S11 shown in FIG. 1 according to some embodiments of the present disclosure.
FIG. 4 is a schematic flowchart of operations executed after a block S15 shown in FIG.1 according to some embodiments of the present disclosure.
FIG. 5 is a specific schematic flowchart of identifying whether the at least one phase corresponds to a single phase or multiple phases.
FIG. 6 is a schematic flowchart of a current-sampling method according to some embodiments of the present disclosure.
FIG. 7 is a schematic diagram of pulse transforming processes according to some embodiments in FIG. 6.
FIG. 8 is a schematic diagram of a chip according to some embodiments of the present disclosure.
FIG. 9 is a schematic diagram of a sampling apparatus for a phase current of a motor according to some embodiments of the present disclosure.

### DETAILED DESCRIPTION

The description provides specific details for a thorough understanding about the embodiments of the present disclosure, such as certain system structures and techniques, which is for interpretation but not limitation of the present disclosure. However, a person skilled in the art should understand, it is possible to implement the present disclosure in other embodiments without these specific details. In other cases, detailed descriptions of well-known systems, devices, circuits and methods are omitted so as not to interfere with the description of the present disclosure by unnecessary details.

It should be understood that, in the description and claims of the present disclosure, the term "include/comprise" is used to indicate the existence of the described features, units, steps, operations, elements and/or parts, but does not exclude the existence or addition of one or more other features, units, steps, operations, elements, parts and/or the combinations of them.

It should be understood that, the terms used in the description are intended solely to describe specific embodiments and are not intended to limit the present disclosure. As used in the description and claims of the present disclosure, singular forms "a", "an" and "the" are intended to include the plural, unless otherwise clearly indicated by the context.

It should also be understood that, the term "and/or" used in the description and claims of the present disclosure is intended to indicate any combinations and all possible combinations of one or more of the items listed accordingly, and all these combinations are included.

As used in the description and claims of the present disclosure, the term "if" may be interpreted based on context as "when" or "once" or "in response to identifying" or "in response to detecting". Similarly, the phrases "if it is identified that" or "if it is detected that [described condition or event]" may be interpreted depending on the context as "once it is identified that" or "in response to the identification of" or "once it is detected that [described condition or event]" or "in response to the detection of [described condition or event]".

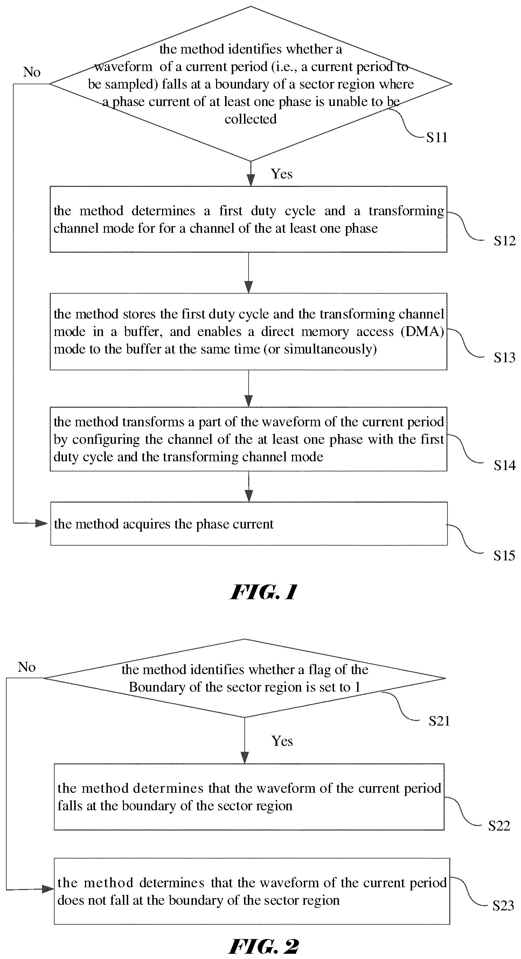

In order to illustrate the technical solutions of the present disclosure, some embodiments will be described below. A current-sampling method is provided in some embodiments of the present disclosure, and the method is based on a pulse waveform as an example. FIG. 1 is a schematic flowchart of a current-sampling method according to a first embodiment of the present disclosure. The sampling method includes operations in the following blocks.

At S11, the method identifies whether a waveform of a current period (i.e., a current period to be sampled) falls at a boundary of a sector region where a phase current of at least one phase is unable to be collected.

A pulse period is actually a time duration of a pulse, and generally corresponds to a pulse width. The pulse width is technically a length of time or duration that a current or a voltage changes regularly with time.

A current sampling region in the pulse period includes a non-sector region and a sector region. Generally, as long as the pulse width meets a certain width condition in the pulse period, a phase current may be obtained in the non-sector region. However, the phase current cannot be obtained in a special sector region.

To make it possible to obtain the phase current in the sector region, generally in a motor control system, it is necessary to identify a waveform of the current period, to determine whether the waveform of the current period falls at the boundary of the sector region, in particular, to identify whether the pulse waveform of the current period falls at the boundary of the sector region. Herein, the boundary of the sector region refers to the above mentioned special sector region.

At S12, the method determines a first duty cycle and a transforming channel mode for a channel of the at least one phase.

When the waveform of the current period falls at the boundary of the sector region, it means that the phase current is unable to be collected through the channel of the at least one phase corresponding to the waveform of the current period, and it is impossible to control the motor operation effectively since the phase current of the at least one phase is unable to be collected. In order to better control the motor even at the boundary of the sector region, the waveform is required to be transformed. Thus, it is necessary to determine the transforming channel mode and the first duty cycle. The transforming channel mode may also be understood as a waveform shape, and the first duty cycle is a duty cycle of the channel.

The duty cycle is a ratio of the time occupied by the pulse to a total time during a period of continuous working time. The extended meaning of the duty cycle is a ratio of a duration of a phenomenon to the total time in periodic phenomena.

At S13, the method stores the first duty cycle and the transforming channel mode in a buffer, and enables a direct memory access (DMA) mode to the buffer at the same time (or simultaneously).

After determining the first duty cycle and the transforming channel mode, the first duty cycle and the transforming channel mode may be stored in the buffer to update the buffer, that is, the first duty cycle and the transforming channel mode of the channel may be stored in the buffer, and the DMA mode may be enabled at the same time (or simultaneously). When the waveform of the current period needs to be transformed, the DMA transfers or carries parameters from the buffer to transform the waveform of the current period. The parameters in the buffer include at least two parameters, namely a duty cycle and a channel mode, such as the first duty cycle and the transforming channel mode.

At S14, the method transforms a part of the waveform of the current period by configuring the channel of the at least one phase with the first duty cycle and the transforming channel mode.

Generally, the waveform of the current period may be transformed by configuring the channel of the at least one phase with the first duty cycle and the transforming channel mode. In some embodiments, the part of the waveform of the current period may be transformed, to construct a phase-current sampling region. For example, a pulse width modulation (PWM) waveform may be controlled to transform through the DMA mode, to construct the phase-current sampling region.

In addition, a waveform phase shifting scheme may be implemented to reverse the waveform twice in a period of rising and falling. In this way, it is possible to construct the required phase-current sampling region, reduce the current sampling distortion of running a single resistor, and reduce a noise of the current. Specific limitations are not defined here.

At S15, the method acquires the phase current.

A current sampling region from which the phase current is able to be collected may be constructed based on the transformed waveform of the current period. Then the phase current may be collected. For example, one of two phase currents may be collected in the non-sector region, and the other of the two phase currents needs to be collected in the sector region. Of course, there are other combinations, of which limitations are not defined here.

Therefore, in some embodiments of the present disclosure, distortion of the current sampling may be reduced and an efficiency of the current sampling may be improved by employing a phase-current sampling method for motor control including operations: identifying whether a waveform of a current period falls at a boundary of a sector region where a phase current of at least one phase is unable to be collected; determining a first duty cycle and a transforming channel mode for a channel of the at least one phase; storing the first duty cycle and the transforming channel mode in a buffer, and enabling a direct memory access (DMA) mode to the buffer at the same time; transforming a part of the waveform of the current period by configuring the channel of the at least one phase with the first duty cycle and the transforming channel mode, such that the condition of acquiring phase current samples may be satisfied at the boundary of the sector region, and the phase current may be acquired at the boundary of the sector region.

FIG. 2 is a specific schematic flowchart of operations executed in the block S11 shown in FIG. 1 according to some embodiments of the present disclosure. Furthermore, the identifying whether the waveform of the current period falls at the boundary of the sector region includes operations in the following blocks.

At S21, the method identifies whether a flag (i.e., flag setting) of the boundary of the sector region is set to 1.

In order to identify the boundary of the sector region, it is necessary to check the boundary of the sector region corresponding to the waveform of the current period. In some embodiments, whether the waveform of the current period falls at the boundary of the sector region may be identified by checking whether the flag of the boundary of the sector region is set to 1.

In response to the flag being set to 1, it means that the waveform of the current period falls at the boundary of the sector region. In this case, the method goes to S22, that is, the method determines that the waveform of the current period falls at the boundary of the sector region. In response to the flag not being set to 1, for example being set to 0, it means that the waveform of the current period does not fall at the boundary of the sector region. In this case, the method goes to S23, that is, the method determines that the waveform of the current period does not fall at the boundary of the sector region.

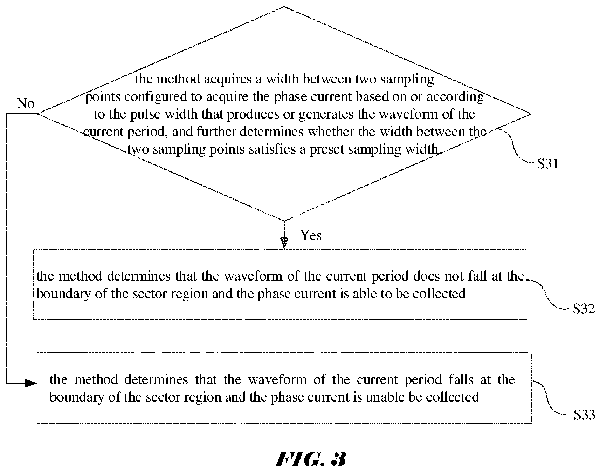

FIG. 3 is another specific schematic flowchart of operations executed in the block S11 shown in FIG. 1 according to some embodiments of the present disclosure. Furthermore, the identifying whether the waveform of the current period falls at the boundary of the sector region includes operations in the following blocks.

At S31, the method acquires a width between two sampling points configured to acquire the phase current based on or according to the pulse width that produces or generates the waveform of the current period, and further determines whether the width between the two sampling points satisfies a preset sampling width.

Generally, in a pulse modulation period, the generated waveform of the current period occupies a certain width of the pulse modulation period. Normally, the motor system will have a preset sampling width in which the current is sampled. In addition, based on the pulse width that generates the waveform of the current period or the time at which the pulse is generated, the width between the two sampling points for acquiring the phase current may be acquired, and whether the width between the two sampling points satisfies the preset sampling width may be checked or determined, to determine whether to acquire the phase current.

If it is determined that the width between the two sampling points satisfies the preset sampling width, the method goes to S32, that is, the method determines that the waveform of the current period does not fall at the boundary of the sector region and the phase current is able to be collected. If it is determined that the width between the two sampling points fails to satisfy the preset sampling width, the method goes to S33, that is, the method determines that the waveform of the current period falls at the boundary of the sector region and the phase current is unable be collected. In this case, it is necessary to transform the part of the waveform of the current period.

The transforming the part of the waveform of the current period by configuring the channel of the at least one phase with the determined first duty cycle and the transforming channel mode further includes the following operations.

In some embodiments, the part of the waveform of the current period may be transformed in at least one way of inverting, hollowing, and compensating by utilizing the first duty cycle and the transforming channel mode. That is, reflected on the waveform of the current period, the transformation includes at least one of inverting, hollowing, and compensating of the waveform of the current period.

In some other embodiments, the DMA mode may be directly enabled at the same time of or in response to determining the first duty cycle and the transforming channel mode. In this case, the enabled DMA mode may be utilized to transfer the first duty cycle and the transforming channel mode from the buffer to a channel register of the channel of the at least one phase, to configure the channel of the at least one phase, so as to implement the transformation of the part of the waveform of the current period.

In some other embodiments, the method identifies whether the at least one phase corresponds to a single phase or multiple phases. In response to identifying the at least one phase corresponding to the single phase, the method transforms the part of the waveform of the current period for the single phase. In response to identifying the at least one phase corresponding to the multiple phases, the method transforms the part of the waveform of the current period for each phase in the multiple phases.

Further, after the transformation of the part of the waveform of the current period, the sampling method includes the following operations.

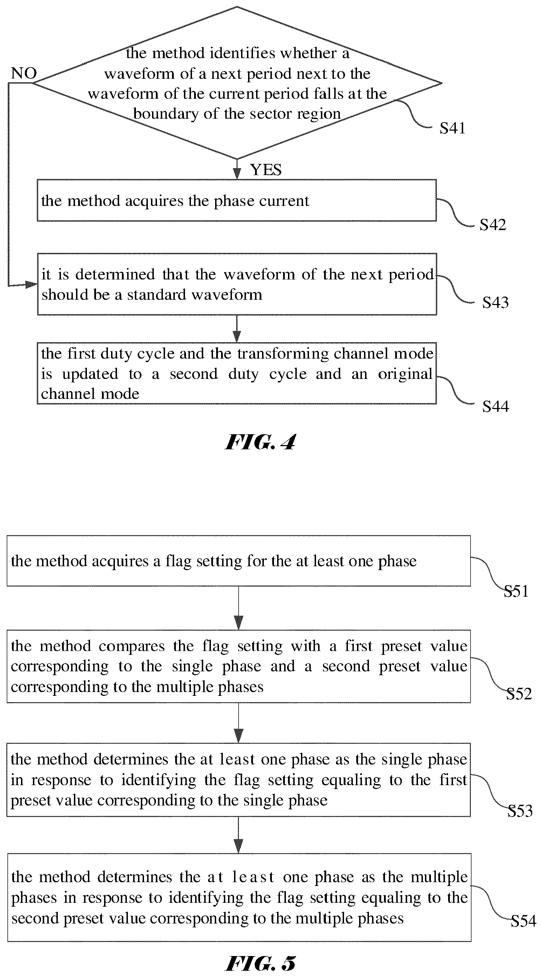

FIG. 4 is a schematic flowchart of operations executed after the block S15 shown in FIG.1 according to the present disclosure. At a waveform of a next period next to or after the waveform of the current period, the current-sampling method also includes operations in the following blocks.

At S41, the method identifies whether a waveform of a next period next to the waveform of the current period falls at the boundary of the sector region.

In response to the waveform of the next period falling at the boundary of the sector region, it may be determined that the waveform of the next period is consistent with the transformed waveform of the current period. At this time, the first duty cycle and the transforming channel mode are continuously used to configure the channel of the at least one phase. In this case, the method directly goes to S42, that is, the method acquires the phase current.

In response to the waveform of the next period not falling at the boundary of the sector region, the method goes to S43, and it is determined that the waveform of the next period should be a standard waveform which is different from the non standard waveform of the current period. In this case, when needing to restore the waveform of the next period to the standard waveform, the method goes to S44, the first duty cycle and the transforming channel mode is updated to a second duty cycle and an original channel mode.

In some embodiments of the present disclosure, the first duty cycle and the transforming channel mode in the buffer are replaced with the second duty cycle and the original channel mode. In this way, the second duty cycle and the original channel mode in the buffer is transferred to the channel register of the channel the at least one phase by the DMA mode, to configure the channel of the at least one phase. Therefore, the method further includes an operation of restoring the waveform of the next period according to the standard waveform by configuring the channel of the at least one phase with the second duty cycle and the original channel mode.

Further, the restoring the waveform of the next period according to the standard waveform by configuring the channel of the at least one phase with the second duty cycle and the original channel mode may include the following operations.

In some embodiments, the waveform of the next period may be directly restored as the standard waveform, by configuring the channel of the at least one phase with the second duty cycle and the original channel mode.

In some embodiments, the method identifies whether the at least one phase corresponds to a single phase or multiple phases. In response to identifying the at least one phase corresponding to the single phase, the method restores the waveform of the next period according to the standard waveform for the single phase. In response to identifying the at least one phase corresponding to the multiple phases, the method restores the waveform of the next period according to the standard waveform for each phase in the multiple phases.

In some other embodiments, a part of the waveform of the next period may be restored as the standard waveform in at least one way of inverting, hollowing, and compensating, by utilizing the second duty cycle and the original channel mode, such that the waveform of the next period may be restored to the original standard wave form, that is, the waveform which is not at the boundary of the sector region. For example, the waveform hollowed during the transformation may be restored to the original waveform without hollow.

It should be noticed that, it is the second duty cycle that is used for restoring the waveform, rather than the first duty cycle. That is, the duty cycle is overwriting-stored in the buffer. The duty cycle is updated for every time of transformation, so the restored waveform will not be affected, and the amount of data stored in the buffer and transferred by the DMA is reduced. The stored channel mode may be the original channel mode or the transforming channel mode. Besides, the channel mode configured for the transformation may be overwritten every time, so the storage space may be saved.

Further, the at least one phase may be identified as the single phase or the multiple phases. FIG. 5 is a specific schematic flowchart of identifying whether the at least one phase corresponds to a single phase or multiple phases according to some embodiments of the present disclosure. For the transformation of the single-phase waveform or the waveform of each phase in the multi-phase waveform, the phase current may be sampled separately with the above described current-sampling method. At S51, the method acquires a flag setting for the at least one phase.

Generally, the flag setting may be set for the waveform of the current period or the waveform of the next period to determine whether the at least one phase corresponds to the single phase or the multiple phases. For example, if the at least one phase of the waveform of the current period correspond to a single phase, the flag setting corresponding to the single phase may be acquired. If the at least one phase of the waveform of the current period correspond to multiple phases, the flag setting corresponding to the multiple phases may be acquired.

At S52, the method compares the flag setting with a first preset value corresponding to the single phase and a second preset value corresponding to the multiple phases.

In some embodiments, the first preset value corresponding to the single phase or the second preset value corresponding to the multiple phases is set for the at least one phase of the waveform of the current period or that of the waveform of the next period. The first preset value and the second preset value may be compared with the acquired flag setting for the at least one phase, and thereby identifying a dimension of the at least one phase (that is, identifying whether the at least one phase corresponds to the single phase or the multiple phases).

At S53, the method determines the at least one phase as the single phase in response to identifying the flag setting equaling to the first preset value corresponding to the single phase.

In some embodiments, the phase current may be sampled with the above described current-sampling method from the single-phase waveform.

At S54, the method determines the at least one phase as the multiple phases in response to identifying the flag setting equaling to the second preset value corresponding to the multiple phases.

In some embodiments, the multiple phases include at least two phases. The phase current may be sampled with the above described current-sampling method from the waveform of each phase in the multi-phases.

The current-sampling method based on the pulse waveform is described in detail in combination with specific application scenarios. The motor may include three phases including PWM_V, PWM_W and PWM_U. The single-resistance sampling mechanism of motor control is to collect analog/digital converter (ADC) data of two phase currents within a PWM waveform. However, only the ADC data of one of the two phase currents may be obtained under certain conditions of the boundary of the sector region. Thus, the PWM waveform needs to be transformed to construct the current-sampling region. The DMA is automatically triggered to modify the PWM configuration in a certain window (i.e., the sector region) in the PWM period, by the way of transferring the PWM configuration via the DMA. In this way, the PWM waveform may be transformed, and thus the current-sampling region may be constructed.

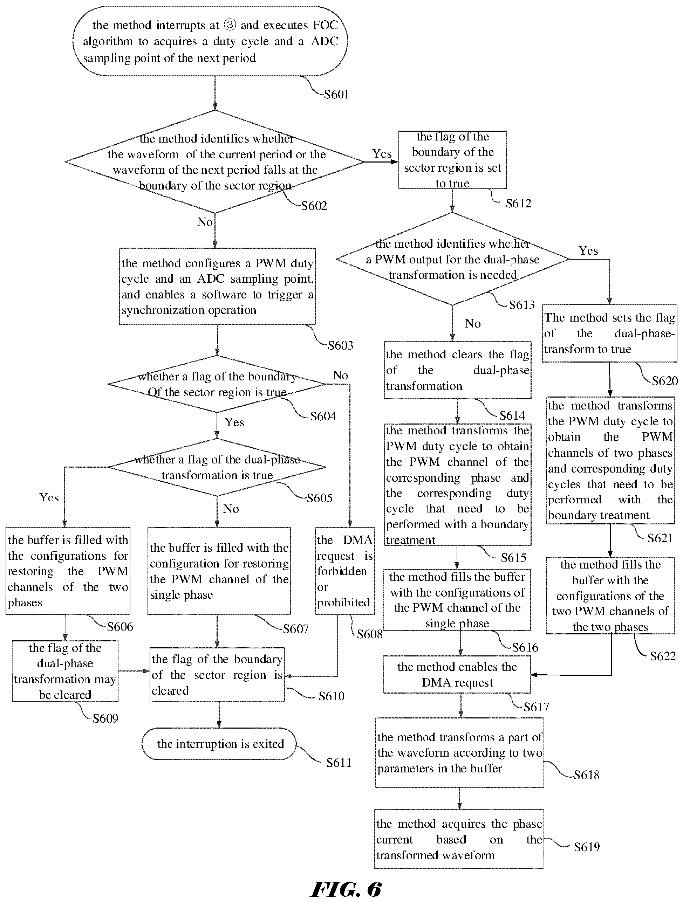

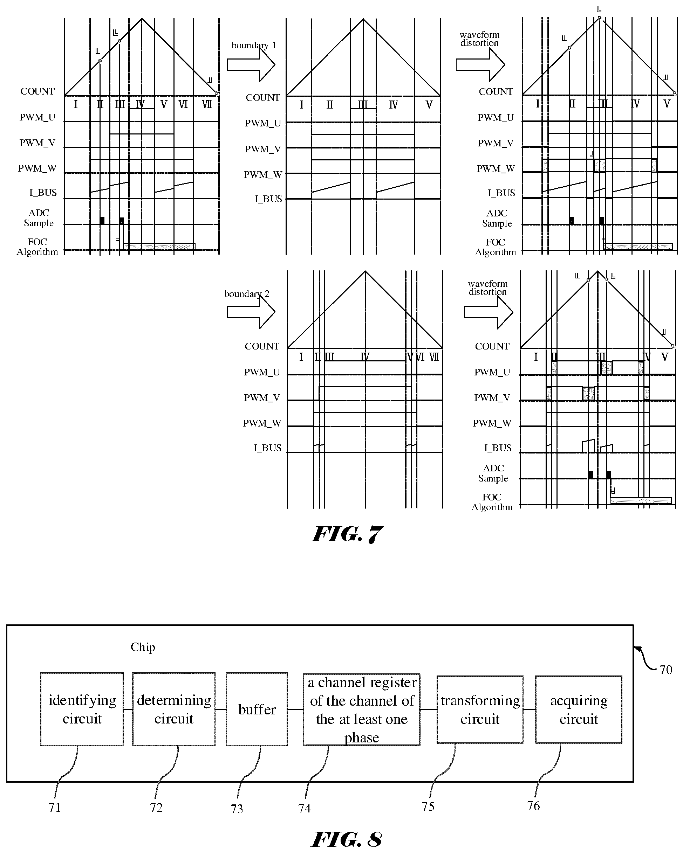

FIG. 6 is a schematic flowchart of a current-sampling method according to some embodiments of the present disclosure. FIG. 7 is a schematic diagram of pulse transforming processes according to some embodiments in FIG. 6. Two boundary scenarios, named boundary 1 and boundary 2, are provided in FIG. 7. As shown in FIG. 7, there is no enough black region in the ADC Sample for sampling; in this case, only one phase current may be collected or no phase current can be acquired, and two-phase current signals cannot be acquired at the boundary of the sector region. Therefore, the PWM waveform needs to be transformed to produce deformation in a middle part of the waveform, and the ADC data of the two phase currents may be acquired from the transformed waveform. As shown in FIGS. 6 and 7, the application scenario according to some specific embodiments includes the following operations.

At S601, the method interrupts at ③ and executes FOC algorithm to acquires a duty cycle and a ADC sampling point of the next period. Herein, the current sampling may be interrupts at ③, and the FOC algorithm may be executed.

As shown in FIG. 7, COUNT is a count of periods, which includes at least seven blocks **I, II, III,** IV, V, VI and VII. There are also numerical markers such as ①, ②, ③, ④, ⑤ and ⑥ on the pulse period for labeling different regions on the pulse period.

At S602, the method identifies whether the waveform of the current period or the waveform of the next period falls at the boundary of the sector region.

In some embodiments, the method identifies whether the waveform of the current period or the waveform of the next period falls at the boundary of the sector region. In response to the waveform falling at the boundary of the sector region, the method goes to S612. In response to the waveform not falling at the boundary of the sector region, the method goes to S603.

In the scenario boundary 1, in a middle part of an upper half of FIG. 7, a pulse modulation waveform (i.e., PWM waveform) of the PWM_V phase is consistent with a pulse modulation waveform of the PWM_W phase, while a pulse modulation waveform of PWM_U phase is inconsistent with the pulse modulation waveform of the PWM_W phase. Thus, it may be observed from the I_BUS that no phase current is sampled at the boundary of the sector region.

In the scenario boundary 2, in a middle part of a lower half of FIG. 7, the pulse modulation waveform of the PWM_U phase, the PWM_V phase, and the PWM_W phase are inconsistent with each other. Thus, it may be observed from the I_BUS that no phase current is sampled in both the non-boundary of the sector region and the boundary of the sector region.

At S603, the method configures a PWM duty cycle and an ADC sampling point, and enables a software to trigger a synchronization operation.

In case that the waveform is in a normal sector region, the method executes a regular PWM control, such as normal restoring operations of PWM configurations in the flowchart. There are two types of PWM configurations configured for restoring, the one is the configurations of a PWM channel of a single phase, the other is the configurations of the PWM channels of two phases. Whether a single-phase transformation or a dual-phase transformation is performed may be determined according to the flag setting. Then the duty cycle and the PWM configurations configured for restoring are filled in an array of the buffer. After a request for a DMA transferring event is received from hardware, the PWM configurations may be restored in a certain window.

The operation of configuring the PWM duty cycle and the ADC sampling point and enabling the software to trigger the synchronization operation may be implemented by using a watchdog to identify whether a DMA event is called (that is, whether the request for the DMA transferring event is received) after identifying that the waveform of the next period does not fall at the sector region. Herein, to identify whether a DMA event is called after identifying that the waveform of the next period does not fall at the sector region includes two operations: identifying that the waveform of the next period does not fall at the sector region; and identifying whether the request for the DMA transferring event is received. Of course, the watchdog is not necessary, and a piece of code in a program for triggering the calling of the DMA event (that is, triggering the request for the DMA transferring event) may also be used, which may not be limited here.

At A604, the method identifies whether a flag of the boundary of the sector region is true.

If the flag of the boundary of the sector region is true, it means that the waveform of a previous period of the waveform of the next period is a non-standard waveform and has already been transformed subsequently. In response to the waveform of the next period not falling at the boundary of the sector region and the waveform of the previous period of the waveform of the next period having already been transformed, it may be determined that the waveform of the next pulse period should be a standard waveform, and the waveform of the next period needs to be restored to the standard waveform.

At A605, the method identifies whether a flag of the dual-phase transformation is true.

In response to the flag of the dual-phase transformation being true, the method goes to S606, that is, the buffer is filled with the configurations for restoring the PWM channels of the two phases. Specifically, the buffer may be filled with a third duty cycle and an original channel mode of a first phase corresponding to the PWM channels of two phases, and a fourth duty cycle and an original channel mode of a second phase corresponding to the PWM channels of two phases. Then the method goes to S609, and the flag of the dual-phase transformation may be cleared.

In response to the flag of the dual-phase transformation being false, the method goes to S607, that is, the buffer is filled with the configuration for restoring the PWM channel of the single phase. Specifically, the buffer may be filled with a duty cycle and an original channel mode of the phase corresponding to the PWM channel of the single phase. Then the method goes to S610, and the flag of the boundary of the sector region may be cleared.

If the flag of the boundary of the sector region is false, it means that the waveform of a previous period of the waveform of the next period is a standard waveform and has not been transformed. In response to identifying the flag of the boundary of the sector region is false, the method goes to S608, that is, the DMA request (that is, the request for the DMA transferring event) is forbidden or prohibited. Then the method goes to S610, and the flag of the boundary of the sector region is cleared. After the flag of the boundary of the sector region is cleared, the method goes to S611, and the interruption is exited.

In response to identifying the waveform of the current period falls at the boundary of the sector region, the phase current is unable to be collected, and the waveform of the current period needs to be transformed, then the method goes to S612, the flag of the boundary of the sector region is set to true.

At S613, the method identifies whether a PWM output for the dual-phase transformation is needed.

It may be identified through the motor control detection that the waveform of the current period falls at the boundary of the sector region, and the waveform transformation process needs to be executed in this case. Due to a diversity of waveforms, it is necessary to determine whether the PWM output for the dual-phase transformation is needed. Based on the determination that the PWM output for the dual-phase transformation is needed, the method goes to S620. Based on the determination that the PWM output for the dual-phase transformation is unneeded, the method goes to S614.

At S614, the method clears the flag of the dual-phase transformation.

Clearing the flag of the dual-phase transformation means that the single-phase transformation is needed in this case. If it is the single-phase transformation, the method only needs to configure the duty cycle and the transforming channel mode for the PWM channel of the single phase.

At S615, the method transforms the PWM duty cycle to obtain the PWM channel of the corresponding phase and the corresponding duty cycle that need to be performed with a boundary treatment.

In some embodiments, when the waveform falls at the boundary of the sector region, as shown in a right part of the upper half of FIG. 7, one phase of the PWM_V phase and the PWM_W phase is adjusted for transformation. The black solid portion is hollowed by changing the channel configuration values, and the hollowed portion is compensated to both ends of the waveform to raise the ends of the waveform, thereby forming light gray portions. In this way, the waveform is transformed, to construct the reasonable region for the sampling of the phase current. Thus, it is possible to acquire two samples of the phase current.

At S616, the method fills the buffer with the configurations of the PWM channel of the single phase.

If the flag setting is set to the single-phase transformation, the configurations of the PWM channel of the single phase including the duty cycle and the transforming channel mode corresponding to the single phase are filled in the array of the buffer. After the request for the DMA transferring event is received from hardware, the PWM configurations may be restored in the certain window.

At S617, the method enables the DMA request.

The channel configuration values are put in the array of the buffer, that is, the duty cycle and the transforming channel mode corresponding to the single phase are put in the array of the buffer. In some embodiments, in response to the triggering event being triggered, the duty cycle and the transforming channel mode corresponding to the single phase are enforced to be assigned to the PWM waveform through the DMA mode, and thus the PWM waveform is transformed.

At S618, the method transforms a part of the waveform according to two parameters in the buffer.

In some embodiments, the two parameters in the buffer are the duty cycle and the transforming channel mode corresponding to the single phase. The part of the waveform is transformed in at least one way of inverting, hollowing, and compensating, according to the duty cycle and the transforming channel mode corresponding to the single phase. The transformed waveform represents at least one way of inverting, hollowing, and compensating.

At S619, the method acquires the phase current based on the transformed waveform.

At S620, the method sets the flag of the dual-phase transformation to true.

In response to needing to perform the dual-phase transformation, the method needs to configure the PWM channel and configurations for both two phases at the same time. Values related to the duty cycles are filled in the buffer array firstly. After the configuration, the DMA request is enabled. After the request of a DMA transferring event is received from hardware, the PWM configurations may be restored in the certain window.

At A621, the method transforms the PWM duty cycle to obtain the PWM channels of two phases and corresponding duty cycles that need to be performed with the boundary treatment.

Generally, the waveform of one phase of the two phases is transformed according to a fifth duty cycle and a fifth transforming channel mode of the one phase of the two phases. The waveform of the other phase of the two phases is transformed according to a sixth duty cycle and a sixth transforming channel mode of the other phase of the two phases.

For example, as shown in FIG. 7, at the scenario boundary 2, since the regional differences between the PWM_U phase, the PWM_V phase, and the PWM_W phase are small, the width of the I_BUS is too narrow to sample the phase current. Then any two of the three phases are adjusted to be transformed. The black solid portion is hollowed by changing the channel configuration values, and the hollowed portion is compensated to both ends of the waveform to raise the ends of the waveform, thereby forming the light gray portions. In this way, a sample may be taken in a first half of a counting cycle, and another sample may be taken in a second half of the counting cycle. Thus, it is possible to acquire two samples of the phase current.

At S622, the method fills the buffer with the configurations of the two PWM channels of the two phases.

If the flag setting is set to the dual-phase transformation, the fifth duty cycle and the fifth transforming channel mode, and the sixth duty cycle and the sixth transforming channel mode are configured in the array of the buffer array, and the request for the DMA transferring event from hardware is waited for, that is the enabling of DMA request is waited for. Then the method goes to S617, which is not repeated here.

Therefore, the combination of chip hardware module support and software algorithms is needed to implement the control method. For example, hardware functions are needed for PWM triggering DMA events, DMA transferring the PWM configurations to the registers, or the like. At the same time, the software is needed to be in coordinate with the hardware for executing corresponding algorithms in a certain time sequence to implement the objective function.

In this way, the configuration procedures may be reduced by simplifying PWM configuration registers, such that the amount of data transferred by the DMA may be reduced, and a PWM control window may be enlarged accordingly. The motor control system is applicable for the algorithm control of the FOC single-resistance motor. The method implements the PWM waveform transformation by configuring hardware to request for the DMA transferring of the configurations to registers or configuring a piece of code in a program to request for the DMA transferring of the configurations to registers. In this way, it is possible to simplify the software process and improve the real-time control. Moreover, different peripheral modules on the chip may work together, and the application scenarios of the product may be expanded.

In some embodiments, the current-sampling method includes: identifying whether a waveform of a current period falls at a boundary of a sector region where a phase current of at least one phase is unable to be collected; determining a first duty cycle and a transforming channel mode for a channel of the at least one phase; storing the first duty cycle and the transforming channel mode in a buffer, and enabling a direct memory access (DMA) mode to the buffer at the same time; transforming a part of the waveform of the current period by configuring the channel of the at least one phase with the first duty cycle and the transforming channel mode; and acquiring the phase current of the at least one phase based on a transformed waveform of the current period.

In some embodiments, the transforming a part of the waveform of the current period by configuring the channel of the at least one phase with the first duty cycle and the transforming channel mode, includes: transforming the part of the waveform of the current period in at least one way of inverting, hollowing, and compensating, by utilizing the first duty cycle and the transforming channel mode.

In some embodiments, the transforming a part of the waveform of the current period by configuring the channel of the at least one phase with the first duty cycle and the transforming channel mode, includes: transforming the part of the waveform of the current period by transferring the first duty cycle and the transforming channel mode from the buffer to a channel register of the channel of the at least one phase by utilizing the enabled DMA mode and configuring the channel of the at least one phase.

In some embodiments, the transforming the part of the waveform of the current period by transferring the first duty cycle and the transforming channel mode from the buffer to a channel register of the channel of the at least one phase by utilizing the enabled DMA mode and configuring the channel of the at least one phase, includes: identifying whether the at least one phase corresponds to a single phase or multiple phases; in response to identifying the at least one phase corresponding to the single phase, transforming the part of the waveform of the current period for the single phase; and in response to identifying the at least one phase corresponding to the multiple phases, transforming the part of the waveform of the current period for each phase in the multiple phases.

In some embodiments, the sampling method further includes: identifying whether a waveform of a next period next to the current period falls at the boundary of the sector region; determining that the waveform of the next period should be a standard waveform in response to the waveform of the next period not falling at the boundary of the sector region; and updating the first duty cycle and the transforming channel mode to a second duty cycle and an original channel mode.

In some embodiments, after the updating the first duty cycle and the transforming channel mode to a second duty cycle and an original channel mode, the sampling method further includes: transferring the second duty cycle and the original channel mode from the buffer to a channel register of the channel of the at least one phase by utilizing the enabled DMA mode; and restoring the waveform of the next period according to the standard waveform by configuring the channel of the at least one phase with the second duty cycle and the original channel mode.

In some embodiments, the restoring the waveform of the next period according to the standard waveform by configuring the channel of the at least one phase with the second duty cycle and the original channel mode, includes: restoring a part of the waveform of the next period in at least one way of inverting, hollowing, and compensating according to the standard waveform, by utilizing the second duty cycle and the original channel mode.

In some embodiments, the restoring the waveform of the next period according to the standard waveform by configuring the channel of the at least one phase with the second duty cycle and the original channel mode, includes: identifying whether the at least one phase corresponds to a single phase or multiple phases; in response to identifying the at least one phase corresponding to the single phase, restoring the waveform of the next period according to the standard waveform for the single phase; and in response to identifying the at least one phase corresponding to the multiple phases, restoring the waveform of the next period according to the standard waveform for each phase in the multiple phases.

In some embodiments, the identifying whether the at least one phase corresponds to a single phase or multiple phases, includes: acquiring a flag setting for the at least one phase; comparing the flag setting with a first preset value corresponding to the single phase; determining the at least one phase corresponding to the single phase in response to identifying the flag setting equaling to the first preset value.

In some embodiments, the identifying whether the at least one phase corresponds to a single phase or multiple phases, includes: acquiring a flag setting for the at least one phase; comparing the flag setting with a second preset value corresponding to multiple phases; determining the at least one phase corresponding to the multiple phases in response to identifying the flag setting equaling to the second preset value.

In some embodiments, the sampling method further includes: acquiring the phase current based on the waveform of the next period in response to the waveform of the next period falling at the boundary of the sector region.

In some embodiments, the identifying whether the waveform of the current period falls at the boundary of the sector region, includes: acquiring a width between two sampling points configured to acquire the phase current based on a pulse width of the waveform of the current period; determining whether the width between the two sampling points satisfies a preset sampling width; determining that the waveform of the current period does not fall at the boundary of the sector region in response to the width between the two sampling points satisfying the preset sampling width, and collecting the phase current; and determining that the waveform of the current period falls at the boundary of the sector region in response to the width between the two sampling points not satisfying the preset sampling width, the phase current is unable to be collected.

In addition, a second aspect of the embodiments of the present disclosure provides a chip 70. FIG. 8 is a schematic diagram of the chip according to some embodiments of the present disclosure. The chip 70 includes the following modules.

An identifying circuit 71 is configured to identify whether a waveform of a current period falls at a boundary of a sector region where a phase current of at least one phase is unable to be collected.

A determining circuit 72 is configured to determine a first duty cycle and a transforming channel mode for a channel of the at least one phase.

A buffer 73 is configured to store the first duty cycle and the transforming channel mode.

A channel register of the channel of the at least one phase 74, configured to receive the first duty cycle and the transforming channel mode transferred by an enabled direct memory access (DMA) mode.

A transforming circuit 75 is configured to enabling the DMA mode to the buffer at the same time with the first duty cycle and the transforming channel mode being stored in the buffer, and further configured to transform a part of the waveform of the current period by transferring the first duty cycle and the transforming channel mode from the buffer to the channel register of the channel of the at least one phase by utilizing the enabled DMA mode and configuring the channel of the at least one phase.

An acquiring circuit 76 is configured to acquire the phase current of the at least one phase based on a transformed waveform of the current period.

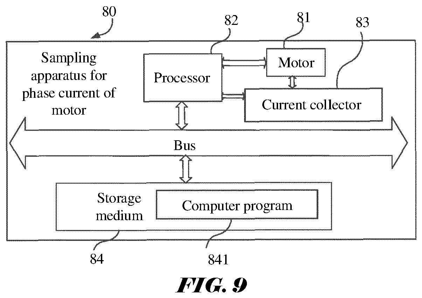

FIG. 9 is a schematic diagram of a sampling apparatus for a phase current of a motor according to some embodiments of the present disclosure. A third aspect of the embodiments of the present disclosure provides a sampling apparatus for a phase current of a motor 80. The sampling apparatus 80 includes a motor 81, a processor 82, a current collector 83, and a storage medium 84. The current collector 83 and the processor 82 are both connected to the motor 81. The storage medium 84 stores a computer program 841. The processor 82 is configured to execute the computer program 841 to perform the current-sampling method provided in preceding embodiments, which is not repeated here, to transform the PWM waveforms generated by the motor 81, such that the current collector 83 may collect two phase currents.

In addition, the units may be stored in a computer-readable storage medium if implemented in the form of software functional units and sold or used as an independent product. Based on this understanding, the technical solution of the present disclosure essentially, or a part that contributes to the existing technology, or all or part of the technical solution may be embodied in the form of a software product, where the computer software product is stored in a storage medium, including several instructions (computer programs) causing a computing device (may be a personal computer, a server, or a network side device, etc.) or a processor execute all or part of the steps in the methods described in the various embodiments of the present disclosure. And the storage medium may include: USB flash disks, mobile hard disks, read-only memory (ROM), random access memory (RAM), magnetic disks, or CDs, and electronic devices that comprising the storage medium, such as PCs, mobile phones, laptops, tablets, or cameras.

The description on the execution process of the computer programs stored in the computer-readable storage medium is not repeated here. Please refer to the description of the current-sampling method in the sampling apparatus for motor phase currents according to some embodiments of the present disclosure.

## Claims

1. A current-sampling method, comprising:
identifying (S11) whether a waveform of a current period falls at a boundary of a sector region where a phase current of at least one phase is unable to be collected;
determining (S12) a first duty cycle and a transforming channel mode for a channel of the at least one phase;
storing (S13) the first duty cycle and the transforming channel mode in a buffer, and enabling a direct memory access (DMA) mode to the buffer at the same time;
transforming (S14) a part of the waveform of the current period by configuring the channel of the at least one phase with the first duty cycle and the transforming channel mode; and
acquiring (S15) the phase current of the at least one phase based on a transformed waveform of the current period;
wherein the method further comprises:
identifying (S41) whether a waveform of a next period next to the current period falls at the boundary of the sector region;
determining (S43) that the waveform of the next period should be a standard waveform in response to the waveform of the next period not falling at the boundary of the sector region; and
updating (S44) the first duty cycle and the transforming channel mode to a second duty cycle and an original channel mode, wherein the second duty cycle and the original channel mode is used to configure the channel of the at least one phase to restore the waveform of the next period.

2. The sampling method according to claim 1, wherein the transforming (S14) a part of the waveform of the current period by configuring the channel of the at least one phase with the first duty cycle and the transforming channel mode, comprises:
transforming the part of the waveform of the current period in at least one way of inverting, hollowing, and compensating, by utilizing the first duty cycle and the transforming channel mode.

3. The sampling method according to any one of claims 1-2, wherein the transforming (S14) a part of the waveform of the current period by configuring the channel of the at least one phase with the first duty cycle and the transforming channel mode, comprises:
transforming the part of the waveform of the current period by transferring the first duty cycle and the transforming channel mode from the buffer to a channel register of the channel of the at least one phase by utilizing the enabled DMA mode and configuring the channel of the at least one phase.

4. The sampling method according to claim 3, wherein the transforming the part of the waveform of the current period by transferring the first duty cycle and the transforming channel mode from the buffer to a channel register of the channel of the at least one phase by utilizing the enabled DMA mode and configuring the channel of the at least one phase, comprises:
identifying whether the at least one phase corresponds to a single phase or multiple phases;
in response to identifying the at least one phase corresponding to the single phase, transforming the part of the waveform of the current period for the single phase; and
in response to identifying the at least one phase corresponding to the multiple phases, transforming the part of the waveform of the current period for each phase in the multiple phases.

5. The sampling method according to claim 1, wherein after the updating (S44) the first duty cycle and the transforming channel mode to a second duty cycle and an original channel mode, the sampling method further comprises:
transferring the second duty cycle and the original channel mode from the buffer to a channel register of the channel of the at least one phase by utilizing the enabled DMA mode; and
restoring the waveform of the next period according to the standard waveform by configuring the channel of the at least one phase with the second duty cycle and the original channel mode.

6. The sampling method according to claim 5, wherein the restoring the waveform of the next period according to the standard waveform by configuring the channel of the at least one phase with the second duty cycle and the original channel mode, comprises:
restoring a part of the waveform of the next period in at least one way of inverting, hollowing, and compensating according to the standard waveform, by utilizing the second duty cycle and the original channel mode.

7. The sampling method according to any one of claims 5-6, wherein the restoring the waveform of the next period according to the standard waveform by configuring the channel of the at least one phase with the second duty cycle and the original channel mode, comprises:
identifying whether the at least one phase corresponds to a single phase or multiple phases;
in response to identifying the at least one phase corresponding to the single phase, restoring the waveform of the next period according to the standard waveform for the single phase; and
in response to identifying the at least one phase corresponding to the multiple phases, restoring the waveform of the next period according to the standard waveform for each phase in the multiple phases.

8. The sampling method according to claim 7, wherein the identifying whether the at least one phase corresponds to a single phase or multiple phases, comprises:
acquiring (S51) a flag setting for the at least one phase;
comparing (S52) the flag setting with a first preset value corresponding to the single phase;
determining (S53) the at least one phase corresponding to the single phase in response to identifying the flag setting equaling to the first preset value.

9. The sampling method according to claim 7, wherein the identifying whether the at least one phase corresponds to a single phase or multiple phases, comprises:
acquiring (S51) a flag setting for the at least one phase;
comparing (S52) the flag setting with a second preset value corresponding to multiple phases;
determining (S54) the at least one phase corresponding to the multiple phases in response to identifying the flag setting equaling to the second preset value.

10. The sampling method according to any one of claims 1-9, further comprising:
acquiring the phase current based on the waveform of the next period in response to the waveform of the next period falling at the boundary of the sector region.

11. The sampling method according to any one of claims 1-10, wherein the identifying whether the waveform of the current period falls at the boundary of the sector region, comprises:
acquiring (S31) a width between two sampling points configured to acquire the phase current based on a pulse width of the waveform of the current period and determining whether the width between the two sampling points satisfies a preset sampling width;
determining (S32) that the waveform of the current period does not fall at the boundary of the sector region in response to the width between the two sampling points satisfying the preset sampling width, and collecting the phase current; and
determining (S33) that the waveform of the current period falls at the boundary of the sector region in response to the width between the two sampling points not satisfying the preset sampling width, the phase current is unable to be collected.

12. A chip (70), comprising:
an identifying circuit (71), configured to identify whether a waveform of a current period falls at a boundary of a sector region where a phase current of at least one phase is unable to be collected;
a determining circuit (72), configured to determine a first duty cycle and a transforming channel mode for a channel of the at least one phase;
a buffer (73), configured to store the first duty cycle and the transforming channel mode;
a channel register of the channel of the at least one phase (74), configured to receive the first duty cycle and the transforming channel mode transferred by an enabled direct memory access (DMA) mode;
a transforming circuit (75), configured to enabling the DMA mode to the buffer at the same time with the first duty cycle and the transforming channel mode being stored in the buffer, and further configured to transform a part of the waveform of the current period by transferring the first duty cycle and the transforming channel mode from the buffer to the channel register of the channel of the at least one phase by utilizing the enabled DMA mode and configuring the channel of the at least one phase; and
an acquiring circuit (76), configured to acquire the phase current of the at least one phase based on a transformed waveform of the current period;
wherein the identifying circuit (71) is further configured to identify whether a waveform of a next period next to the current period falls at the boundary of the sector region;
the determining circuit (72) is further configured to determine that the waveform of the next period should be a standard waveform in response to the waveform of the next period not falling at the boundary of the sector region, and update the first duty cycle and the transforming channel mode in the buffer (73) to a second duty cycle and an original channel mode, and wherein the second duty cycle and the original channel mode is used to configure the channel of the at least one phase to restore the waveform of the next period.

13. The chip according to claim 12, wherein the transforming circuit (74) is configured to transform the part of the waveform of the current period in at least one way of inverting, hollowing, and compensating.

14. A sampling apparatus (80) for a phase current of a motor, comprising:
a motor (81), a processor (82), a current collector (83), and a storage medium (84), wherein the current collector (83) and the processor (82) are both connected to the motor (81), the storage medium (84) stores a computer program (841),
**characterized in that** the processor (82) is configured to execute the computer program (841) to perform the current-sampling method as claimed in any one of claims 1-11, to transform pulse width modulation (PWM) waveforms produced by the motor (81), and the current collector (83) is able to collects a phase current.

## Patentansprüche

1. Ein Verfahren zur Stromabtastung, die Folgendes umfasst:
Ermitteln (S11), ob eine Wellenform einer aktuellen Periode an der Peripherie einer zonensektoriellen Region liegt, in der ein Phasenstrom von mindestens einer Phase nicht erfasst werden kann;
Bestimmen (S12) eines ersten Tastverhältnisses und eines Transformationskanalmodus für einen Kanal der mindestens einen Phase;
Speichern (S13) des ersten Tastverhältnisses und des Umwandlungskanalmodus in einem Puffer und gleichzeitiges Aktivieren eines Direct-Memory-Access- (DMA-) Modus für den Puffer;
Umwandeln (S14) eines Teils der Wellenform der aktuellen Periode durch Konfigurieren des Kanals der mindestens einen Phase mit dem ersten Tastverhältnis und dem Umwandlungskanalmodus; und
Erfassen (S15) des Phasenstroms der mindestens einen Phase basierend auf einer umgewandelten Wellenform der aktuellen Periode;
wobei das Verfahren weiter umfasst:
Identifizieren (S41), ob eine Wellenform einer auf die aktuelle Periode folgenden Periode an der Peripherie der Zonen-Sektor liegt;
Bestimmen (S43), dass die Wellenform der nächsten Periode eine Standardwellenform sein soll, wenn festgestellt wird, dass die Wellenform der nächsten Periode nicht an der Peripherie der Zonensektor liegt; und
Aktualisieren (S44) des ersten Tastverhältnisses und des Transformationskanalmodus auf ein zweites Tastverhältnis und einen ursprünglichen Kanalmodus, wobei das zweite Tastverhältnis und der ursprüngliche Kanalmodus zur Konfiguration des Kanals der mindestens einen Phase verwendet werden, um die Wellenform der nächsten Periode wiederherzustellen.

2. Verfahren zur Stromabtastung gemäß Anspruch 1, wobei das Transformieren (S14) eines Teils der Wellenform der aktuellen Periode durch Konfiguration des Kanals der mindestens einen Phase mit dem ersten Tastverhältnis und dem Transformationskanalmodus Folgendes umfasst:
Transformieren des Teils der Wellenform der aktuellen Periode in mindestens einer Weise aus Invertieren, Aushöhlen und Kompensieren unter Verwendung des ersten Tastverhältnisses und des Transformationskanalmodus.

3. Verfahren zur Stromabtastung gemäß irgendeinem der Ansprüche 1 oder 2, wobei das Transformieren (S14) eines Teils der Wellenform der aktuellen Periode durch Konfigurieren des Kanals der mindestens einen Phase mit dem ersten Tastverhältnis und dem Transformationskanalmodus umfasst:
Transformieren des Teils der Wellenform der aktuellen Periode durch Übertragen des ersten Tastverhältnisses und des Transformationskanalmodus vom Puffer in ein Kanalregister des Kanals der mindestens einen Phase unter Verwendung des aktivierten DMA-Modus und durch Konfigurieren des Kanals der mindestens einen Phase.

4. Verfahren zur Stromabtastung gemäß Anspruch 3, wobei das Transformieren des Teils der Wellenform der aktuellen Periode durch Übertragen des ersten Tastverhältnisses und des Transformationskanalmodus vom Puffer in ein Kanalregister des Kanals der mindestens einen Phase unter Verwendung des aktivierten DMA-Modus und durch Konfigurieren des Kanals der mindestens einen Phase umfasst:
Ermitteln, ob die mindestens eine Phase einer einzelnen Phase oder mehreren Phasen entspricht;
wobei, als Reaktion auf die Ermittlung, dass die mindestens eine Phase einer einzelnen Phase entspricht, der Teil der Wellenform der aktuellen Periode für die einzelne Phase transformiert wird; und
als Reaktion auf die Ermittlung, dass die mindestens eine Phase mehreren Phasen entspricht, der Teil der Wellenform der aktuellen Periode für jede Phase der mehreren Phasen transformiert wird.

5. Verfahren zur Stromabtastung gemäß Anspruch 1,
wobei nach dem Aktualisieren (S44) des ersten Tastverhältnisses und des Transformationskanalmodus zu einem zweiten Tastverhältnis und einem ursprünglichen Kanalmodus, das Verfahren ferner umfasst:
Übertragen des zweiten Tastverhältnisses und des ursprünglichen Kanalmodus vom Puffer in ein Kanalregister des Kanals der mindestens einen Phase unter Verwendung des aktivierten DMA-Modus; und
Wiederherstellen der Wellenform der nächsten Periode entsprechend der Standardwellenform durch Konfigurieren des Kanals der mindestens einen Phase mit dem zweiten Tastverhältnis und dem ursprünglichen Kanalmodus.

6. Verfahren zur Stromabtastung gemäß Anspruch 5, wobei das Wiederherstellen der Wellenform der nächsten Periode entsprechend der Standardwellenform durch Konfigurieren des Kanals der mindestens einen Phase mit dem zweiten Tastverhältnis und dem ursprünglichen Kanalmodus Folgendes umfasst:
Wiederherstellen eines Teils der Wellenform der nächsten Periode in mindestens einer der Arten von Invertieren, Aushöhlen und Kompensieren gemäß der Standardwellenform unter Verwendung des zweiten Tastverhältnisses und des ursprünglichen Kanalmodus.

7. Verfahren zur Stromabtastung gemäß einem der Ansprüche 5 oder 6, wobei das Wiederherstellen der Wellenform der nächsten Periode entsprechend der Standardwellenform durch Konfigurieren des Kanals der mindestens einen Phase mit dem zweiten Tastverhältnis und dem ursprünglichen Kanalmodus Folgendes umfasst:
Ermitteln, ob die mindestens eine Phase einer Einzelphase oder mehreren Phasen entspricht;
als Reaktion auf das Ermitteln, dass die mindestens eine Phase der Einzelphase entspricht, Wiederherstellen der Wellenform der nächsten Periode gemäß der Standardwellenform für die Einzelphase; und
als Reaktion auf das Ermitteln, dass die mindestens eine Phase mehreren Phasen entspricht, Wiederherstellen der Wellenform der nächsten Periode gemäß der Standardwellenform für jede Phase der mehreren Phasen.

8. Verfahren zur Stromabtastung gemäß Anspruch 7, wobei das Ermitteln, ob die mindestens eine Phase einer Einzelphase oder mehreren Phasen entspricht, Folgendes umfasst:
Erfassen (S51) eines Phasenindikatorparameters für die mindestens eine Phase;
Vergleichen (S52) des Phasenindikatorparameters mit einem ersten vorgegebenen Wert, der der Einzelphase entspricht;
Bestimmen (S53), dass die mindestens eine Phase der Einzelphase entspricht, als Reaktion auf das Erkennen, dass der Phasenindikatorparameter dem ersten vorgegebenen Wert entspricht.

9. Verfahren zur Stromabtastung gemäß Anspruch 7, wobei das Ermitteln, ob die mindestens eine Phase einer Einzelphase oder mehreren Phasen entspricht, Folgendes umfasst:
Erfassen (S51) eines Phasenindikatorparameters für die mindestens eine Phase;
Vergleichen (S52) des Phasenindikatorparameters mit einem zweiten vorgegebenen Wert, der mehreren Phasen entspricht;
Bestimmen (S54), dass die mindestens eine Phase mehreren Phasen entspricht, als Reaktion auf das Erkennen, dass der Phasenindikatorparameter dem zweiten vorgegebenen Wert entspricht.

10. Verfahren zur Stromabtastung gemäß einem der Ansprüche 1 bis 9, weiterhin umfassend:
Erfassen des Phasenstroms basierend auf der Wellenform der nächsten Periode als Reaktion darauf, dass die Wellenform der nächsten Periode an der Peripherie der Zonenbereich liegt.

11. Verfahren zur Stromabtastung gemäß einem der Ansprüche 1 bis 10, wobei das Erkennen, ob die Wellenform der aktuellen Periode an der Peripherie des Zonenbereichs liegt, Folgendes umfasst:
Erfassen (S31) einer Breite zwischen zwei Abtastpunkten, die zur Erfassung des Phasenstroms auf Basis einer Pulsweite der Wellenform der aktuellen Periode konfiguriert sind, und Ermitteln, ob die Breite zwischen den beiden Abtastpunkten einer vorgegebenen Abtastbreite entspricht;
Feststellen (S32), dass die Wellenform der aktuellen Periode nicht an der Peripherie des Zonenbereichs liegt, wenn die Breite zwischen den beiden Abtastpunkten der vorgegebenen Abtastbreite entspricht, und Erfassen des Phasenstroms; und
Feststellen (S33), dass die Wellenform der aktuellen Periode an der Peripherie des Zonenbereichs liegt, wenn die Breite zwischen den beiden Abtastpunkten der vorgegebenen Abtastbreite nicht entspricht, wobei der Phasenstrom nicht erfasst werden kann.

12. Ein Chip (70), das Folgendes umfasst:
eine Identifizierungsschaltung (71), die eingerichtet ist, zu identifizieren, ob eine Wellenform einer aktuellen Periode an der Peripherie einer Zonensektorielle liegt, in der ein Phasenstrom von mindestens einer Phase nicht erfasst werden kann;
eine Bestimmungsschaltung (72), die eingerichtet ist, einen ersten Arbeitszyklus und einen Transformationskanalmodus für einen Kanal der mindestens einen Phase zu bestimmen;
einen Puffer (73), der eingerichtet ist, den ersten Arbeitszyklus und den Transformationskanalmodus zu speichern;
ein Kanalregister des Kanals der mindestens einen Phase (74), das eingerichtet ist, den ersten Arbeitszyklus und den Transformationskanalmodus zu empfangen, die im aktivierten Direktzugriffsmodus (DMA) übertragen werden;
eine Transformationsschaltung (75), die eingerichtet ist, den DMA-Modus gleichzeitig mit dem Speichern des ersten Arbeitszyklus und des Transformationskanalmodus im Puffer zu aktivieren und ferner dazu eingerichtet ist, einen Teil der Wellenform der aktuellen Periode zu transformieren, indem der erste Arbeitszyklus und der Transformationskanalmodus mittels des aktivierten DMA-Modus vom Puffer an das Kanalregister des Kanals der mindestens einen Phase übertragen werden und der Kanal der mindestens einen Phase konfiguriert wird; und
eine Erfassungsschaltung (76), die eingerichtet ist, den Phasenstrom der mindestens einen Phase basierend auf einer transformierten Wellenform der aktuellen Periode zu erfassen.
wobei die Identifizierungsschaltung (71) ferner eingerichtet ist, zu identifizieren, ob eine Wellenform einer folgenden Periode benachbart zur aktuellen Periode an der Peripherie der zonensektoriellen Zone liegt;
wobei die Bestimmungsschaltung (72) ferner eingerichtet ist, zu bestimmen, dass die Wellenform der folgenden Periode eine Standardwellenform sein soll, falls die Wellenform der folgenden Periode nicht an der Peripherie der zonensektoriellen Zone liegt, und den ersten Arbeitszyklus und den Transformationskanalmodus im Puffer (73) zu einem zweiten Arbeitszyklus und einem Originalkanalmodus zu aktualisieren, wobei der zweite Arbeitszyklus und der Originalkanalmodus zur Konfiguration des Kanals der mindestens einen Phase verwendet werden, um die Wellenform der folgenden Periode wiederherzustellen.

13. Der Chip gemäß Anspruch 12, wobei die Transformationsschaltung (75) konfiguriert ist, den Teil der Wellenform der aktuellen Periode in mindestens einer Invertierungs-, Aushöhlungs- und Kompensationsart zu transformieren.

14. Eine Stichprobenvorrichtung (80) für einen Phasenstrom eines Motors, umfassend:
einen Motor (81), einen Prozessor (82), einen Stromerfasser (83) und ein Speichermedium (84), wobei der Stromerfasser (83) und der Prozessor (82) beide mit dem Motor (81) verbunden sind, und das Speichermedium (84) ein Computerprogramm (841) speichert,
**dadurch gekennzeichnet, dass** der Prozessor (82) dazu konfiguriert ist, das Computerprogramm (841) auszuführen, um das Verfahren zur Stromabtastung gemäß einem der Ansprüche 1 bis 11 durchzuführen, um Pulsweitenmodulationswellenformen (PWM) zu transformieren, die vom Motor (81) erzeugt werden, und der Stromerfasser (83) dazu geeignet ist, einen Phasenstrom zu erfassen.

## Revendications

1. Procédé d'échantillonnage de courant, comprenant :
identifier (S11) si une forme d'onde d'une période actuelle se situe à la périphérie d'une zone sectorielle dans laquelle un courant de phase d'au moins une phase ne peut pas être collecté ;
déterminer (S12) un premier rapport cyclique et un mode de canal de transformation pour un canal d'au moins cette phase ;
stocker (S13) le premier rapport cyclique et le mode de canal de transformation dans une mémoire tampon, et activer en même temps un mode d'accès direct à la mémoire (DMA) vers ladite mémoire tampon ;
transformer (S14) une portion de la forme d'onde de la période en cours en configurant le canal de la dite au moins une phase à l'aide du premier rapport cyclique et du mode de canal de transformation ; et
acquérir (S15) le courant de phase de la dite au moins une phase sur la base d'une forme d'onde transformée de la période de courant ;
où le procédé comprend en outre :
identifier (S41) si une forme d'onde d'une période suivante à la période actuelle se trouve à la périphérie de la zone sectorielle ;
déterminer (S43) que la forme d'onde de la période suivante doit être une forme d'onde standard en réponse au fait que ladite forme d'onde ne se situe pas à la périphérie de la zone sectorielle ; et
mettre à jour (S44) le premier rapport cyclique et le mode de canal de transformation en un second rapport cyclique et un mode de canal d'origine, ledit second rapport cyclique et ledit mode de canal d'origine étant utilisés pour configurer le canal de ladite au moins une phase afin de rétablir la forme d'onde de la période suivante.

2. Le procédé d'échantillonnage selon la revendication 1, dans lequel la transformation (S14) d'une portion de la forme d'onde de la période actuelle, par configuration du canal de ladite au moins une phase à l'aide du premier rapport cyclique et du mode de canal de transformation, comprend :
la transformation de ladite portion de forme d'onde de la période actuelle selon au moins un mode choisi parmi une inversion, un évidement et une compensation, au moyen du premier rapport cyclique et du mode de canal de transformation.

3. Le procédé d'échantillonnage selon une quelconque des revendications 1-2, dans lequel la transformation (S14) d'une portion de la forme d'onde de la période courante en configurant le canal de l'au moins une phase avec le premier rapport cyclique et le mode de canal de transformation, comprend :
la transformation de la portion de la forme d'onde de la période en cours en transférant le premier rapport cyclique et le mode de canal de transformation de la mémoire tampon à un registre de canal du canal d'au moins une phase en utilisant le mode DMA activé et en configurant le canal d'au moins une phase.

4. Le procédé d'échantillonnage selon la revendication 3, dans lequel la transformation de la portion de la forme d'onde de la période actuelle, par transfert du premier rapport cyclique et du mode de canal de transformation de la mémoire tampon vers un registre de canal du canal de ladite au moins une phase, au moyen du mode DMA activé et par configuration dudit canal, comprend :
l'identification de si ladite au moins une phase correspond à une phase unique ou à plusieurs phases.
en réponse à l'identification de ladite au moins une phase comme correspondant à une phase unique, la transformation de la portion de la forme d'onde de la période actuelle pour ladite phase unique ; et
en réponse à l'identification de ladite au moins une phase comme correspondant à plusieurs phases, la transformation de la portion de la forme d'onde de la période actuelle pour chaque phase parmi lesdites phases multiples.

5. Le procédé d'échantillonnage selon la revendication 1, dans lequel, après la mise à jour (S44) du premier rapport cyclique et du mode de canal de transformation en un second rapport cyclique et un mode de canal d'origine, le procédé comprend en outre :
le transfert du second rapport cyclique et du mode de canal d'origine de la mémoire tampon vers un registre de canal du canal de ladite au moins une phase, au moyen du mode DMA activé ; et
la restauration de la forme d'onde de la période suivante selon la forme d'onde standard, par configuration du canal de ladite au moins une phase à l'aide du second rapport cyclique et du mode de canal d'origine.

6. Le procédé d'échantillonnage selon la revendication 5, dans lequel la restauration de la forme d'onde de la période suivante selon la forme d'onde standard, par configuration du canal de ladite au moins une phase à l'aide du second rapport cyclique et du mode de canal d'origine, comprend :
la restauration d'une portion de la forme d'onde de la période suivante, selon au moins une modalité parmi une inversion, un évidement et une compensation, au moyen du second rapport cyclique et du mode de canal d'origine.

7. Le procédé d'échantillonnage selon l'une quelconque des revendications 5 à 6, dans lequel la restauration de la forme d'onde de la période suivante selon la forme d'onde standard, par configuration du canal de ladite au moins une phase à l'aide du second rapport cyclique et du mode de canal d'origine, comprend :
l'identification de si ladite au moins une phase correspond à une phase unique ou à plusieurs phases ;
en réponse à l'identification de ladite au moins une phase comme correspondant à une phase unique, la restauration de la forme d'onde de la période suivante selon la forme d'onde standard pour ladite phase unique ; et
en réponse à l'identification de ladite au moins une phase comme correspondant à plusieurs phases, la restauration de la forme d'onde de la période suivante selon la forme d'onde standard pour chaque phase parmi lesdites phases multiples.

8. Le procédé d'échantillonnage selon la revendication 7, dans lequel l'identification du fait que ladite au moins une phase correspond à une phase unique ou à plusieurs phases, comprend :
l'acquisition (S51) d'un paramètre indicateur de phase pour ladite au moins une phase
la comparaison (S52) dudit paramètre indicateur de phase avec une première valeur prédéfinie correspondant à ladite phase unique ;
la détermination (S53) de ladite au moins une phase comme correspondant à ladite phase unique en réponse à l'identification dudit paramètre indicateur de phase comme étant égal à ladite première valeur prédéfinie.

9. Le procédé d'échantillonnage selon la revendication 7, dans lequel l'identification du fait que ladite au moins une phase correspond à une phase unique ou à plusieurs phases, comprend :
l'acquisition (S51) d'un paramètre indicateur de phase pour ladite au moins une phase
la comparaison (S52) dudit paramètre indicateur de phase avec une deuxième valeur prédéfinie correspondant à plusieurs phases ;
la détermination (S54) de ladite au moins une phase comme correspondant à plusieurs phases en réponse à l'identification dudit paramètre indicateur de phase comme étant égal à ladite deuxième valeur prédéfinie.

10. Le procédé d'échantillonnage selon l'une quelconque des revendications 1 à 9, comprenant en outre :
l'acquisition du courant de phase sur la base de la forme d'onde de la période suivante en réponse à la détection de ladite forme d'onde de la période suivante à la périphérie de la zone sectorielle.

11. Le procédé d'échantillonnage selon l'une quelconque des revendications 1 à 10, dans lequel l'identification du fait que la forme d'onde de la période actuelle se situe à la périphérie de la zone sectorielle, comprend :
l'acquisition (S31) d'une largeur entre deux points d'échantillonnage configurés pour acquérir le courant de phase sur la base d'une largeur d'impulsion de la forme d'onde de la période actuelle, et la détermination du fait que ladite largeur entre les deux points d'échantillonnage satisfait une largeur d'échantillonnage prédéfinie ;
la détermination (S32) que la forme d'onde de la période actuelle ne se situe pas à la périphérie de la zone sectorielle en réponse au fait que ladite largeur entre les deux points d'échantillonnage satisfait ladite largeur d'échantillonnage prédéfinie, et la collecte du courant de phase ;
la détermination (S33) que la forme d'onde de la période actuelle se situe à la périphérie de la zone sectorielle en réponse au fait que ladite largeur entre les deux points d'échantillonnage ne satisfait pas ladite largeur d'échantillonnage prédéfinie, le courant de phase ne pouvant pas être collecté.

12. Puce (70), comprenant :
un circuit d'identification (71), configuré pour identifier si une forme d'onde d'une période actuelle se situe à la périphérie d'une zone sectorielle dans laquelle un courant de phase d'au moins une phase ne peut pas être collecté ;
un circuit de détermination (72), configuré pour déterminer un premier rapport cyclique et un mode de canal de transformation pour un canal de ladite au moins une phase ;
une mémoire tampon (73), configurée pour stocker le premier rapport cyclique et le mode de canal de transformation ;
un registre de canal du canal de l'au moins une phase (74), configuré pour recevoir le premier rapport cyclique et le mode de canal de transformation transférés par un mode d'accès direct à la mémoire (DMA) activé ;
un circuit de transformation (75), configuré pour activer le mode DMA vers la mémoire tampon en même temps que le premier rapport cyclique et le mode de canal de transformation sont stockés dans la mémoire tampon, et en outre configuré pour transformer une portion de la forme d'onde de la période actuelle en transférant le premier rapport cyclique et le mode de canal de transformation de la mémoire tampon au registre de canal du canal de l'au moins une phase à l'aide du mode DMA activé et en configurant le canal de l'au moins une phase ; et
un circuit d'acquisition (76), configuré pour acquérir le courant de phase de l'au moins une phase sur la base d'une forme d'onde transformée de la période actuelle ;
dans laquelle le circuit d'identification (71) est en outre configuré pour identifier si une forme d'onde d'une période suivante à la période actuelle se situe à la périphérie de la zone sectorielle ;
le circuit de détermination (72) est en outre configuré pour déterminer que la forme d'onde de la période suivante doit être une forme d'onde standard en réponse à l'identification de ce que ladite forme d'onde ne se situe pas à la périphérie de la zone sectorielle, et pour mettre à jour, dans la mémoire tampon (73), le premier rapport cyclique et le mode de canal de transformation en un second rapport cyclique et un mode de canal d'origine, ledit second rapport cyclique et ledit mode de canal d'origine étant utilisés pour configurer le canal de l'au moins une phase afin de restaurer la forme d'onde de la période suivante.

13. La puce selon la revendication 12, dans laquelle le circuit de transformation (74) est configuré pour transformer la portion de la forme d'onde de la période actuelle selon au moins un mode parmi une inversion, un évidement et une compensation.

14. Appareil d'échantillonnage (80) pour un courant de phase d'un moteur, comprenant
un moteur (81), un processeur (82), un collecteur de courant (83) et un support de stockage (84), le collecteur de courant (83) et le processeur (82) étant tous deux connectés au moteur (81), et le support de stockage (84) stockant un programme d'ordinateur (841),
**caractérisé en ce que** le processeur (82) est configuré pour exécuter le programme d'ordinateur (841) afin de mettre en œuvre le procédé d'échantillonnage de courant selon l'une quelconque des revendications 1 à 11, pour transformer des formes d'onde de modulation de largeur d'impulsion (MLI) produites par le moteur (81), et le collecteur de courant (83) est apte à collecter un courant de phase.
